# EUROPEAN PATENT APPLICATION

(11) **EP 1 211 332 A1**
(43) Date of publication of application: **05.06.2002**
(21) Application number: 00940925.1
(22) Date of filing: 03.07.2000
(51) Int. Cl.: C23C 14/35

(54) **MAGNETRON UNIT AND SPUTTERING DEVICE**

(30) Priority: 02.07.1999 JP 18920599
(71) Applicant: Applied Materials, Inc., Santa Clara, California 95054 (US)
(72) Inventor: Aida, Hisashi, Applied Materials Japan, Inc., Narita-shi, Chiba 286-8516 (JP); Hashimoto, Shunichi, Applied Materials Japan, Inc., Narita-shi, Chiba 286-8516 (JP); Akiba, Fuminori, Applied Materials Japan, Inc., Narita-shi, Chiba 286-8516 (JP); Hara, Koji, Applied Materials Japan, Inc., Narita-shi, Chiba 286-8516 (JP); Hinata, Naoki, Applied Materials Japan, Inc., Narita-shi, Chiba 286-8516 (JP)
(74) Representative: Draper, Martyn John
(86) International application number: JP0004404
(87) International publication number: WO0102618

(57) **Abstract**

In a magnetron unit comprising a plurality of magnet units fixed on a base plate, for forming a magnetic field inside the vacuum chamber of a sputtering apparatus, the magnetron unit is characterized in that the unit is constructed so that the lines of magnetic force of adjacent magnet units are in equilibrium. In such a construction, there is a decrease in the lines of magnetic force that are directed toward the substrate to be treated (semiconductor wafer) from the target of the sputtering apparatus, so that the self-bias on the surface of the substrate can be suppressed to a low value or to zero. Accordingly, the effect of ion bombardment on the substrate can be reduced, so that an increase in internal stress can be prevented.

## Description

### TECHNICAL FIELD

The present invention relates to a film forming method using magnetron sputtering, a magnetron type sputtering apparatus used to form a film such as a titanium nitride film or the like, and a magnetron unit used for the sputtering apparatus.

### BACKGROUND ART

The sputtering method is known as one film formation technique in semiconductor manufacturing processes. The sputtering method refers to a method in which film formation is accomplished by bombarding the surface of a target constituting a cathode with positive ions of a treatment gas, ordinarily argon ions, in a plasma, and depositing target particles (hereafter referred to as "sputtered particles") that are sputtered from this surface on a semiconductor wafer on the anode side.

Furthermore, such sputtering methods include a method known as the reactive sputtering method, which is used to form thin films of compounds such as TiN films. This reactive sputtering method is a method in which a thin film of such a compound is formed by introducing an inert gas (e. g., nitrogen gas) into the chamber in addition to argon gas, ionizing this inert gas by means of a plasma, and reacting [this ionized gas] with the sputtered particles (e. g., titanium) on the surface of the wafer.

In a film forming apparatus which utilizes such a sputtering method, i. e., a sputtering apparatus, a so-called magnetron system (magnetron sputtering) is widely employed in order to improve the sputtering efficiency by increasing the plasma density in the vicinity of the surface of the target. In this system, a magnetron unit which has a plurality of magnet units is disposed on the back surface side of the target, and a magnetic field is generated in the vicinity of the target inside the vacuum chamber. Since those lines of magnetic force in this magnetic field that intersect the electric field between the target and the wafer confine the electrons from the target into a region located in the vicinity of the target, the plasma density in this region is increased.

A conventional magnetron unit comprises a circular base plate which is disposed parallel to and coaxially with the target on the back surface side of the target, and magnet units which are fastened to the undersurface of this base plate. The base plate is connected to a driving source that rotationally drives the base plate, so that the magnetic field formed by the magnet units moves in the circumferential direction.

In cases where sputtering is performed using a magnetron type sputtering apparatus, the internal stress of the resulted thin film may be a strong compressive stress. In particular, it has been confirmed that the internal stress reaches considerable levels in the case of remote (long throw) sputtering.

Here, the term "remote sputtering method" refers to a method in which the distance between the target and the semiconductor wafer is longer than in a conventional standard sputtering apparatus. In this method, sputtered particles that advance at a large angle relative to the semiconductor wafer reach regions outside the wafer, and only sputtered particles that advance in more or less the perpendicular direction are deposited on the wafer. Accordingly, in this method, overhang in hole entrance parts can be prevented, so that finer wiring patterns can be handled.

If the internal stress of the thin film exceeds a standard value (this standard value fluctuates in processes preceding and following the process in question), fine cracks might be generated in the thin film as a result of warping of the semiconductor wafer; consequently, there is a danger that problems will occur in the focusing of the subsequent exposure process or the like.

With the foregoing in view, it is an object of the present invention to provide means for reducing the internal stress of thin films formed by the sputtering method.

### DISCLOSURE OF THE INVENTION

The present inventors conducted various investigations in order to achieve the abovementioned object; as a result, the inventors discovered that the magnetic field formed by the magnetron unit has an effect on the internal stress of the thin film. To describe this in greater detail, in cases where the component of the lines of magnetic force in the magnetic field formed by the magnetron unit that is oriented toward the semiconductor wafer is greater than the component that is parallel to the target, the electrons in the plasma are drawn out toward the semiconductor wafer, so that a self-bias is generated at the surface of the wafer. As a result, it appears that the positive ions in the plasma bombard the film on the semiconductor wafer, so that the compressive internal stress in the film increases. Especially in the case of remote sputtering, since the distance to the semiconductor wafer is long, the ions directed toward the semiconductor wafer are accelerated and have a high kinetic energy; as a result, the compressive internal stress is further increased.

Accordingly, the film forming method using magnetron sputtering in accordance with the present invention is a film forming method in which a sputtering target and a substrate to be treated facing this sputtering target are placed inside a chamber, a process gas is introduced into the chamber, and a film is formed on the surface of the substrate by generating a plasma on the erosion surface of the sputtering target by means of a magnetron unit, this method being characterized in that sputtering is performed in a state in which the component of the lines of magnetic force of the magnetic field formed by the magnetron unit that leaves this magnetron unit and is directed toward the substrate is reduced compared to the component that leaves the magnetron unit and then again returns to the magnetron unit.

As a result of the use of such a method, there is a decrease in the lines of magnetic force that are directed toward the substrate being treated from the sputtering target, so that the self-bias on the substrate being treated can be suppressed to a low value or to zero. Accordingly, the effect of ion bombardment on the substrate being treated can be reduced, so that an increase in internal stress can be prevented.

Furthermore, in the abovementioned film forming method, the sputtering target is constructed so that this target contains at least titanium, and the process gas contains at least nitrogen; accordingly, this method is especially effective for forming a titanium nitride film on the surface of the substrate.

In this way, a titanium nitride film can be formed on the surface of the substrate, and the compressive internal stress in the titanium nitride film thus formed can be reduced.

Furthermore, another aspect of the present invention is directed to the magnetron unit, and this magnetron unit is a magnetron unit formed by attaching a plurality of magnet units for forming a magnetic field in the vacuum chamber of the sputtering apparatus to a base plate, which is characterized in that a construction is used in which the lines of magnetic force between adjacent magnet units are in equilibrium.

Furthermore, a state in which the component of the lines of magnetic force of the magnetic field formed by the magnetron unit that leaves this magnetron unit and is directed toward the substrate is sufficiently smaller than the component that leaves the magnetron unit and then again returns to this magnetron unit is referred to as an "equilibrium".

In such a construction, there is a decrease in the lines of magnetic force that are directed toward the substrate to be treated (i. e., the semiconductor wafer) from the target of the sputtering apparatus, so that the self-bias on the substrate being treated can be suppressed to a low value or to zero. Accordingly, the effect of ion bombardment on the substrate can be reduced, so that an increase in internal stress can be prevented.

In the abovementioned magnetron unit, the magnet units are attached on the base plate, and have two magnetic pole ends of different polarity that are oriented in the same direction, and that are disposed with a predetermined gap between these magnetic pole ends. A construction can be used in which the magnet units are attached to the base plate in a state in which the respective magnetic pole ends are oriented in the opposite direction from the base plate.

With this arrangement of the magnet units, it is possible to handle the respective magnet units as an integral whole, so that handling is easy. Furthermore, the disposition of the respective magnet units can be selected in a favorable manner on the base plate.

Furthermore, it is preferable to construct a first annular array of magnet units in which the magnet units are disposed such that the magnet units surround a predetermined point, and such that one magnetic pole end of each magnet unit faces in the centripetal direction, while the other magnetic pole end of each magnet unit faces in the centrifugal direction, and to construct a second annular array of magnet units in which the second array is arranged such that one magnetic pole ends of the magnet units in the second array face in the centripetal direction, the one magnetic pole ends being of opposite polarity from the magnetic pole ends in the magnet units of the first array that face in the centrifugal direction, while the other magnetic pole ends of the second array face in the centrifugal direction.

As a result of first and second arrays of magnet units thus being constructed, the magnet units constituting the first array is located on the side that faces in the centripetal direction, and the magnet units constituting the second array is located on the side that faces in the centrifugal direction, so that the respective magnet units are disposed adjacent to each other. In this case, since the magnetic polarities of two magnet units that are adjacent to each other are different, a closed magnetic circuit is formed between these magnet units, so that the lines of magnetic force that are directed toward the substrate are reduced.

Furthermore, the magnet units can also be constructed from flat-plate-form yoke members that make of a ferromagnet, and bar magnets that are fixed on both ends of these yoke members such that a substantially U-shaped part is formed.

The leakage of lines of magnetic force to the back surface side of the yoke members can be sufficiently reduced by constructing the yoke members of the magnet units from a ferromagnetic material.

Furthermore, it is preferable to attach the magnet units on the base plate in a manner that allows the magnet units to be removed.

As a result of using a construction in which the magnet units can be removed from the base plate, the arrangement of the magnet units on the base plate can easily be altered, and the units themselves can easily be replaces in cases where (for example) the strength of the magnetic field is altered.

Furthermore, the present invention is directed to a sputtering apparatus, and this sputtering apparatus comprises a vacuum chamber, holding means for the substrate inside the vacuum chamber, a target disposed with an erosion surface facing the substrate that is held by the holding means, pressure reduction means for reducing the pressure inside the vacuum chamber, gas supplying means for supplying a process gas to the interior of the vacuum chamber, plasma generating means for converting the process gas supplied to the interior of the vacuum chamber into a plasma, and a magnetron unit of the abovementioned construction which is disposed on the opposite side of the target from the erosion surface.

In this construction of the sputtering apparatus, it is possible to perform sputtering in a state in which the component of the lines of magnetic force of the magnetic field formed by the magnetron unit that leaves this magnetron unit and is directed toward the substrate is sufficiently reduced compared to the component that leaves the magnetron unit and then again returns to this magnetron unit, i. e., it is possible to perform sputtering in an equilibrium state. Accordingly, the self-bias on the substrate being treated can be suppressed to a low value or to zero, and as a result of this action, the effect of ion bombardment on the substrate can be reduced, so that an increase in internal stress can be prevented.

Furthermore, a sputtering apparatus according to an aspect of the present invention comprises a chamber, holding means for holding the substrate to be treated inside the chamber, a target disposed with an erosion surface facing the substrate, and a magnetron unit disposed on the opposite side of the target from the erosion surface, this sputtering apparatus being characterized in that the magnetron unit comprises a base plate; a first magnet having a first polarity, the first magnet being disposed in an annular configuration on the base plate which is centered on a point that is offset from the center of rotation of the base plate; a second magnet having a second polarity which is different from the first polarity, the second magnet being disposed on the base plate such that the second magnet surrounds the first magnet in an annular configuration; a third magnet having the first polarity, the third magnet being disposed on the base plate such that the third magnet surrounds the second magnet in an annular configuration; and a fourth magnet having the second polarity, the fourth magnet being disposed on the base plate such that the fourth magnet surrounds the third magnet in an annular configuration.

The first to fourth magnets can be constructed, for example, by arranging a plurality of rod-shaped sub-magnets, respectively. Alternatively, the first to fourth magnets may also include magnets in which the magnets themselves are formed with an annular shape.

Construction of the magnetron unit in this manner results in a state in which the first magnets are disposed closest to the predetermined point, with the second through fourth magnets being successively disposed further in the centrifugal direction. Furthermore, in the case of respective magnets arranged in this manner, magnets that are adjacent on the centripetal and centrifugal sides have different polarities, so that closed magnetic circuits can be formed between these magnets. Moreover, as a result of this action, a magnetron unit can be constructed in an equilibrium state in which the component of the lines of magnetic force that leaves the magnetron unit and is directed toward the substrate is sufficiently smaller than the component of the lines of magnetic force that leaves the magnetron unit and then again returns to the magnetron unit.

The above and other features and advantages of the present invention will become more apparent by reading the following detailed description to those skilled in the art, while referring to the attached drawings.

### BRIEF DESCRIPTION OF THE DRAWINGS

Fig. 1 is a schematic explanatory view showing a preferred embodiment of the present invention;
Fig. 2 shows the magnetron unit in Fig. 1 as viewed from below;
Fig. 3 is a sectional view along line III-III in Fig. 2, showing the construction of the magnet units used in the magnetron unit; and
Fig. 4 is a view of another embodiment of the present invention, showing the magnetron unit as viewed from below.

### BEST MODE FOR CARRYING OUT THE INVENTION

Preferred embodiments of the present invention will be described in detail below with reference to the attached figures.

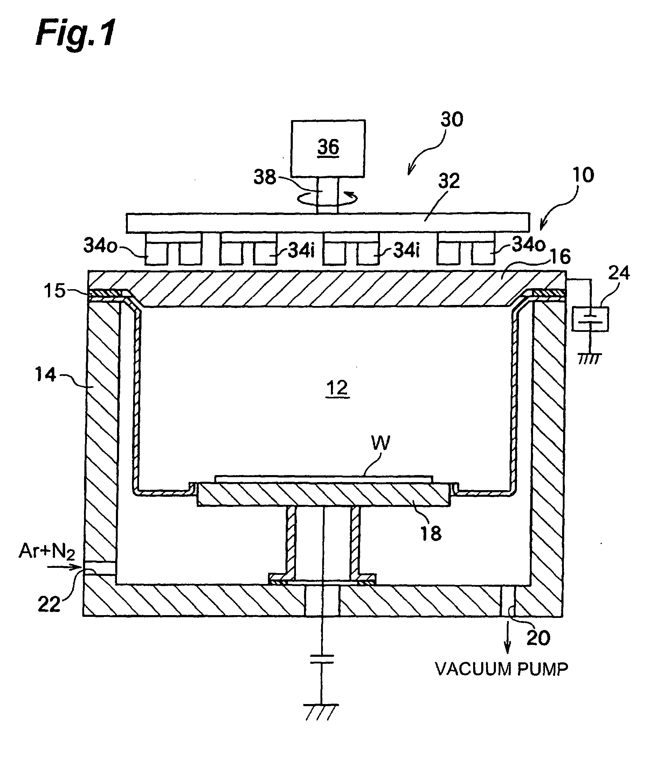

Fig. 1 schematically shows a magnetron type sputtering apparatus in accordance with the present invention. The sputtering apparatus 10 in the present embodiment is used to form a TiN film (titanium nitride film) on the surface of a semiconductor wafer W which is a substrate to be treated. This sputtering apparatus 10 comprises a housing 14 which has a vacuum chamber 12 formed therein, and a disk-form target 16 which is disposed such that the target closes an upper opening portion of the housing 14. The target 16 is constructed from titanium. The housing 14 and the target 16 are both conductive, and an insulating member 15 is sandwiched between the housing 14 and the target 16. The circular undersurface of the target 16 is equivalent to an erosion surface whose entire area is subjected to erosion by sputtering.

A pedestal (holding means) 18 for holding the semiconductor wafer W on the upper surface thereof is disposed inside the vacuum chamber 12. The upper surface of the pedestal 18 is positioned parallel to and facing the undersurface of the target 16. Therefore, the wafer W held in a specified position on the pedestal 18 is parallel to and coaxial with the undersurface of the target 16. In the shown embodiment, the dimensions of the target 16 and the gap between the pedestal 18 and the target 16 are set at values that are greater than those in a conventional standard sputtering apparatus, and a remote sputtering method is applied.

An exhaust port 20 is formed in the housing 14. A vacuum pump (not shown) such as a cryopump or the like is connected to this exhaust port 20, and the pressure inside the vacuum chamber 12 is reduced by operating this vacuum pump. Specifically, the exhaust port 20 and vacuum pump constitute pressure reduction means for reducing the pressure inside the vacuum chamber 12. Furthermore, a mixed gas including argon gas and nitrogen gas is supplied to the interior of the vacuum chamber 12 as a process gas via a port 22 from gas supplying means (not shown).

The cathode of a direct-current power supply 24 as plasma forming means is connected to the target 16, and the anode of the direct-current power supply 24 and the pedestal 18 (i. e., the wafer W) are grounded. When the mixed gas of argon gas and nitrogen gas is introduced into the interior of the vacuum chamber 12, and the direct-current power supply 24 is switched on so that a voltage is applied between the target 16 and pedestal 18, a glow discharge is generated so that a plasma state results. When the argon ions generated by this discharge strike the undersurface of the target 16, titanium particles (sputtered particles) or target atoms are expelled, and these titanium particles are deposited on the wafer W. Furthermore, the nitrogen ions in the plasma are directed toward the anode pedestal 18, and react with the titanium on the wafer W to form a TiN film.

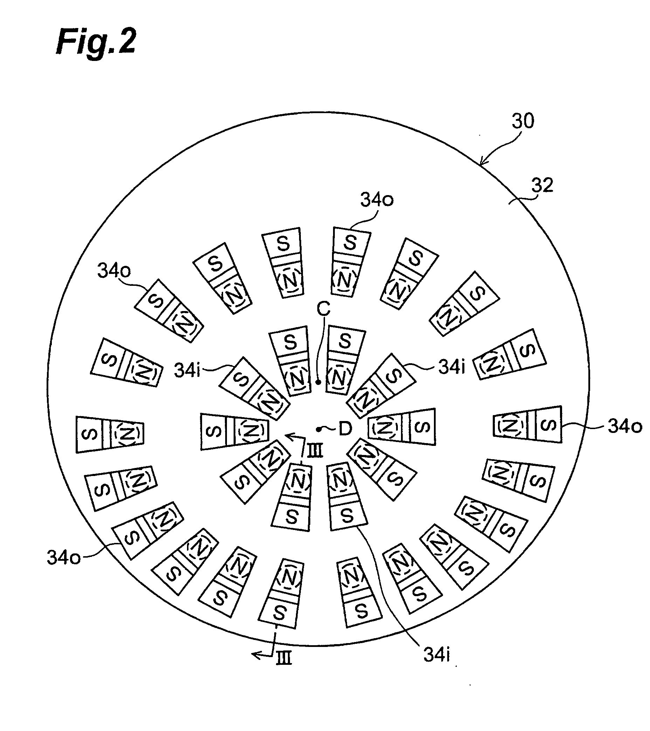

A magnetron unit 30 for increasing the plasma density in the vicinity of the target 16 is disposed on the opposite side of the target 16 from the undersurface, i. e., above the target 16. As is shown in Fig. 2, the magnetron unit 30 comprises a circular base plate 32, and a plurality of magnet units 34 which are attached on the base plate 32 in a specified arrangement. The base plate 32 is positioned coaxially with the target 16 above the target 16, and the rotating shaft 38 of a driving motor 36 is connected to the center C of the upper surface of the base plate 32. Accordingly, when the driving motor 36 is actuated to rotate the base plate 32, the respective magnet units 34 rotate along the upper surface of the target 16 so as to prevent the magnetic fields generated by the respective magnet units from becoming static in one place.

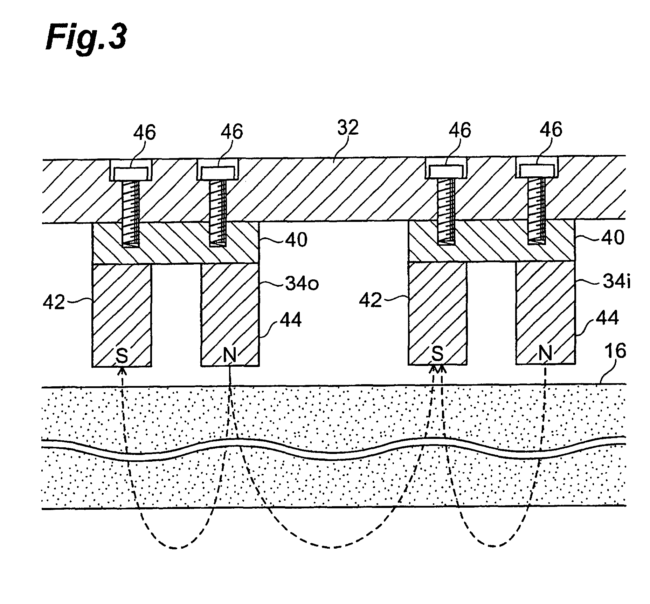

As seen in Fig. 3, each magnet unit 34 is constructed from a flat-plate-form yoke member 40 made of a ferromagnet, and bar magnets 42 and 44 which are fixed on the end portions of the yoke member 40, respectively. The two bar magnets 42 and 44 extend in the same direction. Accordingly, the overall shape of each magnet unit 34 is substantially U-shaped. Furthermore, the free end of one bar magnet 42 is an S pole, while the free end of the other bar magnet 44 is an N pole. In this embodiment, the areas of the end surfaces of the respective bar magnets 42 and 44 are substantially equal. As a result, in the respective magnet units 34, the lines of magnetic force that extend between the magnetic pole end surfaces of the bar magnets 42 and 44 are substantially in equilibrium (see the broken lines in Fig. 3). Specifically, in each magnet unit 34, closed magnetic circuit via the bar magnets 42 and 44 is formed, and the lines of magnetic force directed to the outside of the magnetic circuit are considerably reduced. Furthermore, in the regions of the bar magnets 42 and 44 on the opposite sides from the end surfaces, the magnetic circuit is formed through the yoke member 40 of ferromagnet; accordingly, almost no leakage magnetic flux is generated.

The magnet units 34 are mounted on the base plate 32 by appropriate fastening means such as screws 46 with the back surfaces of the yoke members 40 contacting the base plate 32. In such a construction, the mounting position of the magnet unit 34 can be freely changed.

In the shown embodiment, the magnet units 34 are arranged in the double annular arrangement as shown in Fig. 2. A first array of the magnet units which is located on the inside surrounds a predetermined point D. One magnetic pole end (the N pole in Fig. 2) of each magnet unit 34i (the appended character i indicates the inside annular array) constituting this first magnet unit array faces in the centripetal direction (toward the point D), while the other magnetic pole end (the S pole in Fig. 2) faces in the centrifugal direction (away from the point D). Furthermore, the second magnet unit array which is located on the outside surrounds the first magnet unit array, and one magnetic pole end (the N pole in Fig. 2) of each magnet unit 34o (the appended character o indicates the outside annular row) constituting this second magnet row faces in the centripetal direction, while the other magnetic pole end (the S pole in Fig. 2) faces in the centrifugal direction. With such an annular arrangement, it is preferable that the shape of the magnet units 34 as seen in a plan view (the shape shown in Fig. 2) be trapezoidal in order to avoid any great difference between the inside and outside in the gap between adjacent magnet units in the same row, and in order to facilitate attachment.

As mentioned above, a tunnel-shape magnetic field is formed in each of the magnet units 34. Furthermore, in this embodiment, adjacent magnetic pole ends of a magnet unit 34i and a magnet unit 34o in the first unit array and the second unit array have different polarities. Accordingly, the lines of magnetic force between these adjacent magnet units 34i and 34o are in a state of equilibrium (see Fig. 3). Specifically, most of the component in the magnetic fields formed by adjacent magnet units 34i and 34o is substantially horizontal along the undersurface of the target 16, with very few lines of magnetic force being oriented toward the pedestal 18. In the more concrete, closed magnetic circuits are formed between adjacent magnetic poles among the magnet units 34i and 34o, thus resulting in a state in which there is a considerable decrease in lines of magnetic force that are directed toward the outside of these magnetic circuits.

Accordingly, after a plasma has been generated inside the sputtering apparatus 10, the secondary electrons from the target 16 and electrons in the plasma that are directed toward the pedestal 18 are reduced to an extremely small amount, so that the self-bias at the surface level of the semiconductor wafer W on the pedestal 18 is either zero or a very small value. As a result, the quantity of ions impacting against the TiN film on the surface of the semiconductor wafer W is reduced, so that the compressive internal stress in the TiN film is suppressed to a low value. Furthermore, since the self-bias on the semiconductor wafer W is either zero or an extremely small value, the kinetic energy of the ions directed toward the semiconductor wafer W keeps a small value, in spite of the fact that this embodiment uses remote sputtering. The ion bombardment effect is limited by this as well.

It should be noted that the annular arrays of magnet units 34 shown in Fig. 2 are not perfectly circular, and the position of the point D for these arrays is not disposed at the center C of the base plate 32. This arrangement is adopted in consideration of the fact that the base plate 32 is rotationally driven by the driving unit 28, and the magnetic fields are also caused to move by this movement.

A preferred embodiment of the present invention was described above in detail; however, it goes without saying that the present invention is not limited to the abovementioned embodiment.

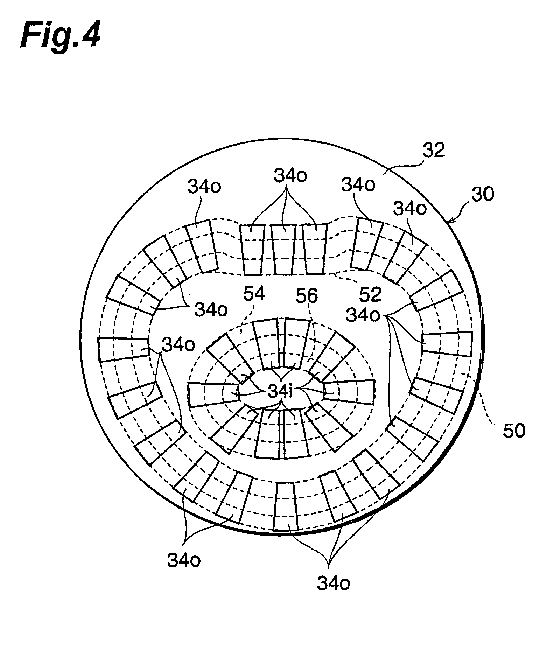

For example, as long as the arrangement and construction of the magnet units 34 in the magnetron unit 30 are such that the magnetic fields formed by these magnet units 34 are in an equilibrium state, i. e., are such that the component of the lines of magnetic force in the magnetic fields that is directed toward the semiconductor wafer is reduced, any such arrangement and construction are included in the present invention. For example, besides a construction in which the magnet units 34 are independently disposed in an annular configuration as shown in Fig. 2, the magnet configuration could also consist of a configuration in which the same magnetic pole ends of a plurality of magnet units 34i and 34o are connected by ferromagnetic bodies 50, 52, 54 and 56 as shown by the dotted lines in Fig. 4. Alternatively, it would also be possible to abandon magnet units 34 altogether, and to dispose a plurality of annular magnets of different diameters in a concentric configuration as shown by the dotted lines in Fig. 4.

Furthermore, the abovementioned embodiment related to an apparatus for remote sputtering; however, the present invention is not necessarily limited to remote sputtering. Similarly, the present invention is not limited to reactive sputtering for the purpose of forming a TiN film. The reason for this is that one of the characteristics of the present invention is the prevention of an increase in the compressive internal stress of the film due to the effect of lines of magnetic force that are directed toward the substrate such as a semiconductor wafer or the like.

### INDUSTRIAL APPLICABILITY

As described in detail above, the present invention makes it possible to reduce the internal stress in a thin film formed by sputtering. Accordingly, the generation of fine cracks in the sputtered film caused by warping of the substrate, and problems arising in focusing in subsequent exposure processes and the like, can be avoided, so that semiconductor devices and the like can be manufactured with a high yield.

As a result, the present invention makes it possible to handle increased device performance in the field of manufacturing electro-microdevices such as semiconductor device and the like.

## Claims

1. A film forming method using magnetron sputtering in which, in a chamber having a sputtering target and a substrate to be treated which faces said sputtering target disposed therein, a film is formed on the surface of said substrate by introducing a process gas into said chamber and generating a plasma on the erosion surface of said sputtering target by means of a magnetron unit, said method being **characterized in that** sputtering is performed in a state in which the component of the lines of magnetic force of the magnetic field formed by said magnetron unit that leaves said magnetron unit and is directed toward said substrate is reduced compared to the component of the lines of magnetic force that leaves said magnetron unit and then again returns to said magnetron unit.

2. The film forming method using magnetron sputtering according to claim 1, said method being **characterized in that** said sputtering target contains at least titanium, said process gas contains at least nitrogen, and a titanium nitride film is formed on the surface of said substrate.

3. A magnetron unit comprising a plurality of magnet units for forming a magnetic field inside a vacuum chamber of a sputtering apparatus, said magnetron unit being constructed so that the lines of magnetic force between said adjacent magnet units are in equilibrium.

4. The magnetron unit according to claim 3, wherein said magnet units each comprise a flat-plate-form yoke member making of a ferromagnet, and bar magnets which are fixed on the ends of said yoke member, respectively, such that each magnet unit is substantially U-shaped.

5. The magnetron unit according to claim 3, wherein said magnet units are attached on a base plate, said magnet units have two magnetic pole ends of different polarities that are oriented in the same direction, and that are disposed with a predetermined gap between these magnetic pole ends, and wherein said magnetic pole ends are oriented in the opposite direction from the base plate.

6. The magnetron unit according to claim 5, wherein said magnet units each comprise a flat-plate-form yoke member making of a ferromagnet, and bar magnets which are fixed on the ends of said yoke member, respectively, such that each magnet unit is substantially U-shaped.

7. The magnetron unit according to claim 5, wherein said magnet units are removably attached on said base plate.

8. The magnetron unit according to claim 5,
wherein said magnet units constitute a first annular magnet unit array and a second annular magnet unit array,
wherein said first array surrounds a predetermined point, said first array being arranged such that one magnetic pole end of each magnet unit faces in the centripetal direction and the other magnetic pole end of each magnet unit faces in the centrifugal direction; and
wherein said second annular magnet unit array surrounds said first array, said second array being arranged such that one magnetic pole ends of the magnet units in said second array face in the centripetal direction, said one magnetic pole ends being of opposite polarity from the magnetic pole ends in the magnet units of the first array that face in the centrifugal direction, and such that the other magnetic pole ends of said second array face in the centrifugal direction.

9. The magnetron unit according to claim 8, wherein said magnet units each comprise a flat-plate-form yoke member making of a ferromagnet, and bar magnets which are fixed on the ends of said yoke member, respectively, such that each magnet unit is substantially U-shaped.

10. The magnetron unit according to claim 8,
wherein said magnet units are removably attached on said base plate.

11. A sputtering apparatus comprising:
a vacuum chamber;
holding means for holding a substrate to be treated inside said vacuum chamber;
a target disposed with an erosion surface facing the substrate held by said holding means;
pressure-reducing means for reducing the pressure inside said vacuum chamber;
gas supplying means for supplying a process gas to the interior of said vacuum chamber;
plasma generating means for transforming the process gas supplied to the interior of said vacuum chamber into a plasma state; and
a magnetron unit disposed on the opposite side of said target from said erosion surface,
wherein said magnetron unit comprises a plurality of magnet units for forming a magnetic field inside said vacuum chamber, and said magnetron units are constructed so that the lines of magnetic force of said adjacent magnet units are in equilibrium.

12. The sputtering apparatus according to claim 11, wherein said magnet units each comprise a flat-plate-form yoke member making of a ferromagnet, and bar magnets which are fixed on the ends of said yoke member, respectively, such that each magnet unit is substantially U-shaped.

13. The sputtering apparatus according to claim 11, wherein said magnet units are attached on a base plate, said magnet units have two magnetic pole ends of different polarities that are oriented in the same direction, and that are disposed with a predetermined gap between these magnetic pole ends, said magnetic pole ends being oriented in the opposite direction from said base plate.

14. The sputtering apparatus according to claim 13, wherein said magnet units each comprise a flat-plate-form yoke member which consists of a ferromagnetic body, and bar magnets which are fastened to the respective end parts of said yoke member so that each magnet unit is substantially U-shaped.

15. The sputtering apparatus according to claim 13, wherein said magnet units are removably attached on said base plate.

16. The sputtering apparatus according to claim 13,
wherein said magnet units constitute a first annular magnet unit array and a second annular magnet unit array,
wherein said first array surrounds a predetermined point, said first array being arranged such that one magnetic pole end of each magnet unit faces in the centripetal direction and the other magnetic pole end of each magnet unit faces in the centrifugal direction; and
wherein said second annular magnet unit array surrounds said first array, said second array being arranged such that one magnetic pole ends of the magnet units in said second array face in the centripetal direction, said one magnetic pole ends being of opposite polarity from the magnetic pole ends in the magnet units of the first array that face in the centrifugal direction, and such that the other magnetic pole ends of said second array face in the centrifugal direction.

17. The sputtering apparatus according to claim 16, wherein said magnet units each comprise a flat-plate-form yoke member making of a ferromagnet, and bar magnets which are fixed on the ends of said yoke member, respectively, such that each magnet unit is substantially U-shaped.

18. The sputtering apparatus according to claim 16, wherein said magnet units are removably attached on said base plate.

19. A sputtering apparatus comprising:
a chamber;
holding means for holding a substrate to be be treated inside said chamber;
a target disposed with an erosion surface facing the substrate; and
a magnetron unit disposed on the opposite side of said target from said erosion surface,
wherein said magnetron unit comprises:
a base plate,
a first magnet having a first polarity, said first magnet being disposed in an annular configuration on said base plate which is centered on a point that is offset from the center of rotation of said base plate;
a second magnet having a second polarity which is different from said first polarity, said second magnet being disposed on said base plate such that said second magnet surrounds said first magnet in an annular configuration;
a third magnet having the first polarity, said third magnet being disposed on said base plate such that said third magnet surrounds said second magnet in an annular configuration; and
a fourth magnet having the second polarity, said fourth magnet being disposed on said base plate such that said fourth magnet surrounds said third magnet in an annular configuration.
